# FASCICULE DE BREVET EUROPEEN

(11) **EP 1 527 661 B1**
(45) Date de publication et mention de la délivrance du brevet: **25.01.2006**
(21) Numéro de dépôt: 03758190.7
(22) Date de dépôt: 30.07.2003
(51) Int. Cl.: H05K 9/00

(54) **STRUCTURE DE FILTRAGE OPTIQUE ET DE BLINDAGE ELECTROMAGNETIQUE**
OPTISCHE FILTERSTRUKTUR MIT ELEKTROMAGNETISCHER ABSCHIRMUNG
OPTICAL FILTERING AND ELECTROMAGNETIC ARMOURING STRUCTURE

(30) Priorité: 05.08.2002 FR 0209925; 14.04.2003 FR 0304636
(43) Date de publication de la demande: 04.05.2005
(73) Titulaire: SAINT-GOBAIN GLASS FRANCE, 92400 Courbevoie (FR)
(72) Inventeur: ZADGOUN, Georges, F-92250 La Garenne Colombes (FR)
(74) Mandataire: Aupetit, Muriel J. C.
(86) Numéro de dépôt international: PCT/FR2003/002416
(87) Numéro de publication internationale: WO 2004/016053

(56) Documents cités:
- EP-A- 0 990 928
- EP-A- 1 196 018
- EP-A- 1 199 738
- WO-A-01/78630
- PATENT ABSTRACTS OF JAPAN vol. 1999, no. 12, 29 octobre 1999 (1999-10-29) & JP 11 194215 A (KYODO PRINTING CO LTD), 21 juillet 1999 (1999-07-21)
- PATENT ABSTRACTS OF JAPAN vol. 1999, no. 08, 30 juin 1999 (1999-06-30) & JP 11 073115 A (KANEBO LTD;NIPPON SHEET GLASS CO LTD), 16 mars 1999 (1999-03-16)

## Description

L'invention a pour objet une structure de filtrage optique et de blindage électromagnétique destinée à être assemblée à au moins un substrat transparent, notamment en verre, la structure comportant au moins deux feuilles en matière plastique, et comprenant ou destiné à être associé aux feuilles un élément conducteur de blindage électromagnétique.

L'invention sera plus particulièrement décrite quant à l'utilisation d'une telle structure de blindage électromagnétique pour un écran de visualisation tel qu'un écran plasma.

Un écran plasma comporte un mélange de gaz plasmagène. (Ne, Xe, Ar) emprisonné entre deux feuilles de verre, et des luminophores disposés sur la face interne de la feuille arrière de l'écran. Le rayonnement lumineux ultraviolet émis par le mélange de gaz plasmagène lors de la décharge plasma entre les deux feuilles de verre interagit avec les luminophores de la face interne de la feuille arrière pour produire le rayonnement lumineux visible (rouge, vert, bleu). Un mécanisme de désexcitation des particules de gaz entre en compétition avec l'émission U.V., ce qui engendre un rayonnement infrarouge entre 800 et 1250 nm dont la propagation, principalement au travers de la face avant de l'écran, peut être à l'origine de perturbations très gênantes, notamment pour les équipements situés à proximités et commandés par infra-rouge, par exemple au moyen de télécommandes.

Outre le rayonnement infrarouge généré par la désexcitation du gaz plasmagène, un rayonnement dans l'orange intense à 590 nm est également émis par le mélange gazeux lorsque celui-ci contient du néon. Ce rayonnement dans l'orange peut être désagréable pour l'oeil du spectateur. De plus, il interagit avec les couleurs bleue et verte du spectre lumineux de sorte qu'il rend une image sur l'écran de visualisation présentant des couleurs bleue et verte qu'on peut qualifier de lavées ou affadies, et une couleur rouge moins franche.

Par ailleurs, comme tous les appareils électroniques, les écrans plasma possèdent des systèmes d'adressage (drivers) qui peuvent générer un rayonnement parasite vis-à-vis d'autres dispositifs avec lesquels ils ne doivent pas interférer tels que microordinateurs, téléphones portables....

Afin d'annihiler, et pour le moins réduire, la propagation de ces rayonnements, une solution consiste à disposer contre la face avant de l'écran une structure à la fois transparente et métallisée pour assurer un blindage électromagnétique.

Un type de structure connu consiste en deux feuilles de matière thermoplastique, en particulier du PVB, entre lesquelles est disposée un réseau de fils métalliques sous forme d'une grille homogène.

Cette grille peut être constituée d'un tissu de fils métalliques collé entre les deux feuilles de PVB par chauffage de la matière thermoplastique.

Une autre solution consiste plutôt à graver une couche de cuivre déposée sur un substrat transparent tel que du PET par une technique usuelle de photolitographie, et d'assembler ce substrat aux feuilles de PVB, le substrat en PET étant inséré entre les deux feuilles de PVB et collé par chauffage de la matière thermoplastique.

Cette structure avantageusement feuilletée avec du PVB étant disposée sur le devant de l'écran de visualisation, dont la face avant est un substrat en verre, permet d'assurer une protection vis-à-vis du spectateur en cas de casse de l'écran en retenant les bris de verre.

La grille métallique assure donc un blindage électromagnétique. Or il est toujours souhaitable d'améliorer les performances d'un filtre de blindage électromagnétique en diminuant encore davantage la transmission des ondes dans l'infrarouge et de lui trouver d'autres propriétés de filtrage tel que de pouvoir couper de manière conséquente la couleur orange. En outre, il est bien sûr souhaitable pour l'oeil du spectateur d'avoir un rendu des couleurs optimum sur l'écran.

Un type de filtre connu pour les vitrages de véhicules automobiles coupant dans certaines longueurs d'ondes est l'association de deux feuilles de PVB dont l'une est constituée par le produit Solar reflective film de la société 3M et l'autre est constituée par le film en PVB Sekisui-Lec® commercialisé par la société SEKISUI. Le produit 3M et le film en PVB de SEKISUI sont clairs et neutres en transmission, le film SEKISUI contenant en outre des particules conductrices. Ce filtre a l'avantage de ne transmettre que 51% de la lumière mais cette lumière est à dominance jaune, dont la longueur d'onde dominante est de 561 nm, ce qui modifie de manière significative le rendu des couleurs sur un écran de visualisation. La lumière présente par ailleurs une pureté de 8% ce qui est considéré comme important par rapport à un taux souhaité inférieur ou égal à 7%. On rappelle que la pureté est définie dans le système de mesure CIE de 1931. Dans ce système, la couleur d'un objet est représentée par un point de coordonnées x, y. La pureté est le rapport de la longueur des segments, dont respectivement, l'un joint l'illuminant à l'extrémité du spectrum locus et passe par le point de coordonnées x, y, et l'autre joint l'illuminant au point de coordonnées x, y. En outre, si ce filtre permet d'obtenir une transmission dans l'infrarouge à 1200 nm au plus égale à 5%, la transmission reste encore de 13% à 850 nm. Enfin, la couleur orange n'est pas suffisamment coupée, la transmission pour la longueur d'onde correspondante étant de 64%.

L'invention a donc pour but de fournir une structure de filtrage optique et de blindage électromagnétique qui permet d'une part de couper suffisamment la couleur orange de longueur d'onde centrée sur 590 nm, et d'autre part, d'accroître encore les performances de filtre dans l'infrarouge, tout en obtenant une lumière transmise adéquate pour ne pas transformer la pureté des couleurs et optimiser le contraste de l'image visible sur un écran de visualisation auquel est associée une telle structure.

Aussi, les inventeurs ont réalisé une structure de blindage électromagnétique qui est caractérisée en ce qu'au moins une feuille est en matière thermoplastique, l'autre feuille constitue une feuille de recouvrement de l'élément conducteur ou de la feuille en matière thermoplastique, et l'une ou les deux feuilles intègrent au moins un pigment minéral ou au moins un colorant organique de façon à réaliser pour la structure un filtre dans la couleur orange de longueur d'onde centrée sur 590 nm.

Selon une caractéristique, l'une des feuilles au moins, la feuille en matière thermoplastique et/ou la feuille de recouvrement, intègre au moins un pigment minéral ou au moins un colorant organique pour constituer un filtre infrarouge dans la gamme des longueurs d'onde de 800 à 1250 nm.

Selon un mode de réalisation, l'une des deux feuilles est neutre tandis que l'autre feuille comporte au moins deux pigments ou colorants qui assurent au travers de la structure, respectivement, le filtre pour la couleur orange et le filtre infrarouge.

Selon un autre mode de réalisation, la feuille en matière thermoplastique comporte un pigment ou un colorant qui assure au travers de la structure le filtre pour la couleur orange ou le filtre infrarouge, et la feuille de recouvrement comporte un pigment ou colorant qui assure le filtre pour la couleur orange ou le filtre infrarouge que n'assure pas l'autre feuille en matière thermoplastique..

Selon une première variante, l'élément conducteur est constitué d'un tissu de fils métalliques associé entre les deux feuilles.

Selon une deuxième variante, l'élément conducteur est constitué d'une grille de fils métalliques déposée sur une feuille de support, composée à base de l'une des matières suivantes, polycarbonate, polyméthyl(métha)acrylate, polyéthylènetéréphthalate, polyether sulfone, polyetherketone, et acyronitrile-styrène copolymère.

Avantageusement, selon cette deuxième variante, la feuille de support de l'élément conducteur constitue la feuille de recouvrement, l'élément conducteur étant agencé entre la première feuille en matière thermoplastique et la feuille de recouvrement. De préférence, la feuille de recouvrement portant l'élément conducteur est revêtue à l'opposé de l'élément conducteur d'un film de protection en polyéthylènetéréphtalate (PET), ou en polychlorure de vinyle (PVC), ou en polypropylène, ou encore en polyéthylène haute densité, et d'épaisseur inférieure ou égale à 60 µm.

Selon une troisième variante, l'élément conducteur est constitué d'une couche métallique, telle qu'à base d'argent, déposée sur une feuille de support qui est constituée par la feuille de recouvrement, ledit élément étant agencé entre la feuille de recouvrement et la première feuille en matière thermoplastique.

Selon une autre caractéristique, la feuille de support de l'élément conducteur est constituée d'une feuille complémentaire en matière plastique qui est feuilletée entre la première feuille thermoplastique et la feuille de recouvrement.

Avantageusement, la première feuille en matière thermoplastique, et la feuille de recouvrement lorsqu'elle ne constitue pas une feuille de support pour l'élément conducteur sont en polyvinylbutyral, ou en polyuréthanne, ou en ethylène-vinyl-acétate.

La structure peut être assemblée à un unique substrat transparent, la première feuille en matière thermoplastique étant assemblée au substrat.

Selon une autre variante, la structure peut être assemblée en feuilleté entre deux substrats transparents, la feuille en matière thermoplastique et la feuille de recouvrement étant respectivement assemblées à chacun des substrats.

Selon une caractéristique, le substrat transparent comporte sur sa face en regard de la feuille en matière thermoplastique une couche métallique telle qu'à base d'argent pour constituer l'élément conducteur lorsque celui-ci est associé à la structure.

La structure assure ainsi pour l'ensemble structure et substrat(s), un filtre infrarouge avec une transmission lumineuse correspondante T_{IR} n'excédant pas 17 %, et un filtre pour la couleur orange avec une transmission lumineuse correspondante T_{NE} comprise entre 20 % et 40 %, l'ensemble structure et substrat(s) présentant un taux de transmission lumineuse dans le visible compris entre 40 % et 60 %, avec une pureté inférieure à 7 %.

Plus particulièrement, le filtre infrarouge assure une transmission à 815 nm d'au plus 17%, une transmission à 870 nm d'au plus 9% et une transmission entre 900 et 1250 nm d'au plus 9%.

La structure de l'invention peut par exemple être associée à la face avant d'un écran de visualisation, tel qu'un écran plasma. Elle peut également être associée à tout dispositif nécessitant un blindage électromagnétique et des filtres dans l'infrarouge et dans l'orange.

Pour un écran de visualisation, le ou les substrats en verre auxquels est associée la structure sont en verre trempé. De préférence, au moins un des substrats en verre comporte une couche antireflets sur la face opposée à la structure. Avantageusement, la feuille de recouvrement comporte un traitement antireflets sur la face opposée à la première feuille en matière thermoplastique. Enfin, la structure peut être directement collée sur la face avant de l'écran.

D'autres avantages et caractéristiques de l'invention apparaîtront à la lecture de la description qui suit en regard des dessins annexés sur lesquels :
- la figure 1 est une vue en coupe de la structure de l'invention ;
- les figures 2 et 5 sont des vues en coupe de variantes de la structure de l'invention ;
- les figures 3, 4 et 5 sont des vues en coupe de la structure de l'invention associée à la face avant d'un écran de visualisation selon plusieurs exemples de réalisation.

On précise tout d'abord que les proportions relatives aux différentes grandeurs, notamment épaisseurs, des éléments de l'invention ne sont pas respectées sur les dessins afin que la lecture en soit facilitée.

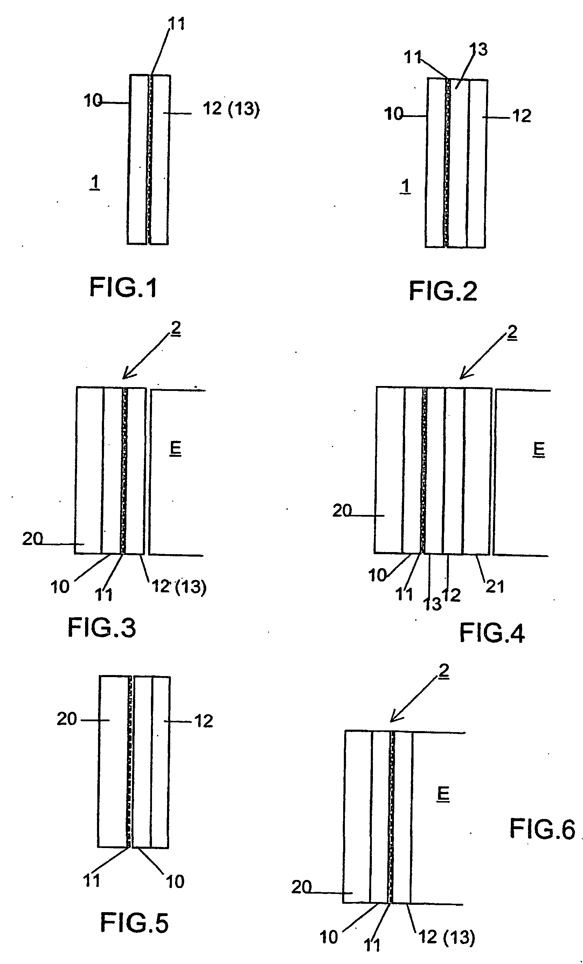

La structure de filtrage optique et de blindage électromagnétique 1 illustrée sur les figures 1 et 2 est destinée à être associée à au moins un substrat transparent, tel qu'un substrat verrier, le substrat étant plus particulièrement destiné à être mécaniquement assemblé contre un écran de visualisation de sorte que la structure constitue pour l'écran un filtre dans la couleur orange et de manière complémentaire si nécessaire un filtre dans l'infrarouge.

L'écran de visualisation est par exemple un écran plasma, celui-ci émettant en particulier un rayonnement dans l'orange en raison du néon contenu dans le mélange gazeux de l'écran. Mais cette utilisation de la structure n'est pas limitée aux écrans plasma et peut être utilisée et associée à tout dispositif nécessitant un filtre dans la couleur orange.

La structure de filtrage optique et de blindage électromagnétique 1 comporte une première feuille en matière thermoplastique 10 et une seconde feuille 12 en matière plastique qui constitue une feuille de recouvrement pour l'élément auquel elle est associée. Un élément conducteur 11 de blindage électromagnétique est compris entre les deux feuilles 10 et 12 ou bien est destiné à être associé aux feuilles lorsqu'il n'est pas compris dans la structure.

L'élément conducteur 11 peut être selon une première variante un tissu de fils métalliques, du type en cuivre, qui est inséré entre les deux feuilles 10 et 12 et assemblé par chauffage des deux feuilles. Dans ce cas, la feuille de recouvrement 12 est de préférence dans la même matière que la première feuille 10, en polyvinylbutyral, ou en polyuréthanne, ou en éthylène-vinyl-acétate.

Selon une seconde variante, l'élément conducteur 11 est une grille de fils métalliques, du type en cuivre, obtenue par une technique usuelle de photolitographie sur une feuille de support en matière plastique à base de l'une des matières suivantes, polycarbonate, polyméthyl(métha)acrylate, polyéthylènetéréphthalate, polyether sulfone, polyétherketone, et acyronitrile-styrène copolymère.

Dans cette seconde variante, la feuille de support de l'élément conducteur 11 peut avantageusement être la feuille de recouvrement 12 qui est alors associée à la première feuille 10 de façon que l'élément conducteur soit agencé entre les deux feuilles, l'assemblage des feuilles se faisant par chauffage des matières (figure 1). Ou bien, la feuille de support de l'élément conducteur 11 peut plutôt être constituée d'une feuille complémentaire 13 qui est feuilletée entre les première et seconde feuilles 10 et 12 qui sont alors de préférence l'une et l'autre dans l'une des matières thermoplastiques suivantes, polyvinylbutyral, ou polyuréthanne, ou éthylène-vinyl-acétate (figure 2).

Selon une troisième variante, l'élément conducteur 11 est une couche à base d'argent déposée sur une feuille de support en matière plastique à base de l'une des matières suivantes, polycarbonate, polyméthyl(métha)acrylate, polyéthylènetéréphthalate, polyether sulfone, polyetherketone, et acyronitrile-styrène copolymère. Cette feuille de support peut avantageusement être la feuille de recouvrement 12, la couche étant agencée entre les deux feuilles 10 et 12 (figure 1).

- Lorsque l'élément conducteur 11 constituant un élément de blindage électromagnétique est non pas intégré à la structure 1 mais lui est associé, l'élément se présente par exemple sous forme de couche métallique, telle qu'à base d'argent, déposée sur le substrat auquel est destinée la structure, la couche se trouvant en regard de la première feuille 10 qu'on vient assembler contre le substrat. C'est l'exemple de la figure 5 sur laquelle on voit un substrat 20 dont une face est pourvue de l'élément conducteur 11 et auquel est associée la structure 1 comportant la première feuille en matière thermoplastique 10 et la feuille de recouvrement 12. La feuille de recouvrement permet d'assurer une autre fonction que la ou les fonctions remplies par la feuille 10, ou de protéger la feuille 10 si celle-ci est faite d'une matière qui peut être facilement rayée par exemple, ou encore de faciliter l'assemblage de la feuille 10 à l'élément qui viendra à l'opposé du substrat.

Pour un meilleur blindage électromagnétique, on préférera la grille de fils métalliques en tant qu'élément conducteur plutôt qu'une couche métallique.

Le filtre optique selon l'invention est obtenu de la manière suivante, l'une ou l'autre des deux feuilles 10 et 12, ou bien les deux feuilles 10 et 12 intègrent au moins un pigment minéral ou au moins un colorant organique pour constituer un filtre dans la couleur orange qui correspond à la longueur d'onde de 590 nm. Le produit FILTRON A178 ou A193 commercialisé par la société GENTEX est un exemple de colorant qu'on peut intégrer dans une feuille polymérique pour constituer un filtre dans l'orange.

La première feuille en matière thermoplastique 10 est en polyvinylbutyral, ou en polyuréthanne, ou en éthylène-vinyl-acétate.

La seconde feuille de recouvrement 12 est dans une matière plastique qui dépend de la fonction assurée par cette feuille, autres que celle de filtre dans l'orange. Des exemples de matière ont été citées plus haut selon la variante considérée pour l'élément conducteur.

Selon l'invention, la structure 1 peut aussi comporter des moyens pour constituer un filtre dans l'infrarouge. Comme pour le filtre dans l'orange, au moins un pigment ou au moins un colorant peut être intégré dans l'une des feuilles 10 ou 12 de la structure, ou dans les deux feuilles pour constituer le filtre infrarouge. Un exemple de colorant pour le filtre infrarouge est le produit FILTRON A195 ou A101 commercialisé par la société GENTEX.

Aussi, au moins l'une des feuilles 10 ou 12, ou au moins la feuille complémentaire 13 lorsque celle-ci est feuilletée entre les deux feuilles 10 et 12, comporte au moins un pigment et/ou au moins un colorant de façon que la structure 1 constitue d'une part un filtre pour l'infrarouge qui correspond aux longueurs d'onde allant, de 800 à 1250 nm, et d'autre part un filtre pour la couleur orange qui correspond à la longueur d'onde centrée sur 590 nm.

Plusieurs variantes de réalisation de la structure peuvent être envisagées quant à l'intégration des colorants ou pigments pour les filtres infrarouge et dans l'orange.

Le colorant ou pigment pour filtre infrarouge et le colorant ou pigment pour filtre de la couleur orange sont tous deux intégrés à l'une des feuilles 10, 12, ou 13, la ou les feuilles ne contenant pas les colorants ou pigments étant de préférence de couleur claire.

En variante, le colorant ou pigment pour filtre infrarouge est intégré à l'une des feuilles 10, 12 ou 13 tandis que le colorant ou pigment pour filtre de la couleur orange est intégré à la feuille ne contenant pas le colorant ou pigment du filtre infrarouge.

Enfin, selon l'invention, la feuille de recouvrement 12 comporte sur la face opposée à celle pourvue de l'élément conducteur 11 lorsque celui-ci est supporté par la feuille, un film de protection 14. Ce film se présente sous la forme d'une feuille en polyéthylènetéréphtalate (PET), ou en polychlorure de vinyle (PVC) ou en polypropylène ou encore en polyéthylène haute densité. Son épaisseur est inférieure ou égale à 60 µm. Il permet d'une part de protéger la face opposée à celle portant l'élément conducteur de façon à éviter toutes rayures de cette face par l'élément conducteur lorsque la feuille est présentée sous forme de rouleau pour sa livraison. D'autre part, ce film de protection sert à créer une surface nette en vue de l'assemblage de la feuille de recouvrement contre une autre surface.

La structure 1 telle que décrite ci-dessus peut donc être associée à un substrat transparent 20, tel qu'un substrat verrier, ou être feuilletée entre deux substrats transparents du type verrier 20 et 21 pour former la face avant 2 d'un écran de visualisation E, c'est-à-dire la partie orientée vers le spectateur.

Un exemple (exemple 1) de réalisation d'assemblage de face avant d'écran au moyen d'une structure 1 associée à un unique substrat 20 est le suivant (figure 3):
- le substrat 20 en regard du spectateur;
- la première feuille thermoplastique 10 qui est en PVB et assemblée au substrat 20 ;
- l'élément conducteur de blindage électromagnétique 11 qui est déposé sur la feuille de recouvrement 12 en PET, cette feuille étant associée d'une part à la première feuille 10 et faisant face d'autre part à l'écran E.

Un autre exemple (exemple 2) de réalisation d'assemblage de face avant d'écran au moyen d'une structure 1 feuilletée entre deux substrats 20 et 21 est le suivant (figure 4):
- le substrat en verre 20 en regard du spectateur
- la première feuille thermoplastique 10 en PVB, assemblée au premier substrat en verre 20;
- l'élément conducteur de blindage électromagnétique 11 déposé sur une feuille complémentaire 13 en PET;
- la seconde feuille de recouvrement 12 en PVB assemblée par l'une des faces à la feuille complémentaire 13 et par sa face opposée au second substrat en verre 21.

Dans les exemples 1 et 2, l'ensemble structure-substrat(s) est fixé mécaniquement sur l'écran au moyen d'un cadre métallique non représenté.

Le filtre constitué au travers de la structure 1, associée à un unique substrat (exemple1) ou feuilletée entre deux substrats verriers 20 et 21 (exemple 2) dans laquelle ont été incorporés des colorants du type FILTRON A195 ou A101 pour l'absorption de la raie du néon à 590 nm et du type FILTRON A178 ou A193 pour l'absorption dans l'infrarouge, est défini par les propriétés suivantes de transmission lumineuse:
- une transmission T_{IR} à 815 nm d'au plus 22%,
- une transmission T_{IR} à 870 nm d'au plus 18%,
- une transmission T_{IR} entre 900 et 1250 nm d'au plus 12%,
- une transmission T_{NE} à 590 nm comprise entre 20 et 40%.

L'association des colorants ou pigments pour les filtres dans l'orange et dans l'infrarouge, combinés éventuellement à d'autres pigments ou colorants absorbant dans le visible, conduit à obtenir une structure 1 associée aux deux substrats verriers dont la transmission lumineuse T_{L} est de l'ordre de 40 à 60% avec les longueurs d'ondes dominantes comprises entre 480 et 520 nm et est associée à une pureté inférieure à 3%. La pureté inférieure à 3% grâce à d'autres pigments ou colorants permet d'obtenir un filtre de couleur grise, c'est-à-dire de couleur neutre en transmission.

La propriété de transmission dans l'infrarouge est appréciée en fonction de la transmission lumineuse dans le visible. Un filtre ayant une transmission dans l'infrarouge élevée, par exemple de l'ordre de 16%, correspondra nécessairement à une transmission dans le visible élevée (de l'ordre de 47%). On choisira donc un compromis entre les transmissions dans l'infrarouge et dans le visible. Par contre, la transmission dans l'orange peut être adaptée quelle que soit la transmission lumineuse dans le visible du filtre.

L'utilisation des filtres dans l'orange et dans l'infrarouge peut conduire à une structure au travers de laquelle la couleur perçue par un spectateur peut être dans une couleur dominante, telle que le vert. De manière à compenser cette couleur pour obtenir une couleur grise neutre qui permet de ne pas affaiblir la teinte des couleurs rendues sur l'écran, on associe soit comme dit plus haut d'autres pigments ou colorants, soit un intercalaire du type PVB teinté absorbant le visible et utilisé classiquement dans les vitrages feuilletés.

La représentation donnée à la figure 6 (exemple 3) présente une variante d'utilisation d'un filtre optique pour écran réalisé suivant l'exemple 1 qui a la particularité d'être directement collé, via la feuille de recouvrement 12 après avoir retiré le film de protection 14 si celui-ci est présent, contre le substrat de la face avant de l'écran à l'aide d'un adhésif ou d'une résine, ou de tout autre moyen connu de l'homme de l'art. L'avantage de ce mode d'assemblage est de supprimer des interfaces optiques et d'abaisser le niveau de réflexion parasite.

Dans les trois exemples de réalisation d'association de la structure à un ou respectivement à deux substrats verriers, et de préférence dans l'exemple de réalisation tout particulièrement qui ne comporte qu'un seul substrat en verre, le ou les substrats en verre sont en verre trempé. Le verre trempé est hautement résistant mécaniquement et casse très difficilement. Ainsi dans les premier et troisième exemples de réalisation, l'épaisseur du filtre total de l'écran, la structure 1 et le substrat en verre 20, permet avantageusement d'être réduite par rapport à l'épaisseur du filtre du second exemple de réalisation incluant deux substrats en verre, tout en gardant les propriétés de protection vis-à-vis du spectateur.

En outre, dans ces trois exemples de réalisation, le ou les substrats en verre seront de préférence revêtus sur leur face externe opposée à la structure 1 d'une couche antireflets. Dans le cas de l'exemple 1 ou 3, la feuille de recouvrement 12 en PET peut avantageusement comporter un traitement antireflets au moyen d'une résine thermosensible ou réticulable aux ultra-violets.

## Revendications

1. Structure (1) de filtrage optique et de blindage électromagnétique destinée à être assemblée à au moins un substrat transparent (20), notamment en verre, la structure comportant au moins deux feuilles en matière plastique (10, 12), et comprenant ou destiné à être associé aux feuilles (10, 12) un élément conducteur de blindage électromagnétique (11), **caractérisée en ce qu'**au moins une feuille (10) est en matière thermoplastique, l'autre feuille (12) constitue une feuille de recouvrement de l'élément conducteur (11) ou de la feuille en matière thermoplastique (10), et l'une ou les deux feuilles intègrent au moins un pigment minéral ou au moins un colorant organique de façon à réaliser pour la structure (1) un filtre dans la couleur orange de longueur d'onde centrée sur 590 nm.

2. Structure selon la revendication 1, **caractérisée en ce que** l'une des feuilles au moins, la feuille en matière thermoplastique (10) et/ou la feuille de recouvrement (12), intègre au moins un pigment minéral ou au moins un colorant organique pour constituer un filtre infrarouge dans la gamme des longueurs d'onde de 800 à 1250 nm.

3. Structure de blindage électromagnétique selon la revendication 2, **caractérisée en ce que** l'une des deux feuilles (10, 12) est neutre tandis que l'autre feuille comporte au moins deux pigments ou colorants qui assurent au travers de la structure, respectivement, le filtre pour la couleur orange et le filtre infrarouge.

4. Structure de blindage électromagnétique selon la revendication 2, **caractérisée en ce que** la feuille en matière thermoplastique (10) comporte un pigment ou un colorant qui assure au travers de la structure le filtre pour la couleur orange ou le filtre infrarouge, et la feuille de recouvrement (12) comporte un pigment ou colorant qui assure le filtre pour la couleur orange ou le filtre infrarouge que n'assure pas l'autre feuille en matière thermoplastique (10).

5. Structure selon l'une quelconque des revendications précédentes, **caractérisée en ce que** l'élément conducteur (11) est constitué d'un tissu de fils métalliques associé entre les deux feuilles (10, 12).

6. Structure selon l'une quelconque des revendications 1 à 4, **caractérisée en ce que** l'élément conducteur (11) est constitué d'une grille de fils métalliques déposée sur une feuille de support, composée à base de l'une des matières suivantes, polycarbonate, polyméthyl(métha)acrylate, polyéthylènetéréphthalate, polyether sulfone, polyetherketone, et acyronitrile-styrène copolymère.

7. Structure selon la revendication 6, **caractérisée en ce que** la feuille de support de l'élément conducteur constitue la feuille de recouvrement (12), l'élément conducteur (11) étant agencé entre la première feuille en matière thermoplastique (10) et la feuille de recouvrement (12).

8. Structure selon la revendication 6 ou 7, **caractérisée en ce que** la feuille de recouvrement (12) portant l'élément conducteur (11) est revêtue à l'opposé de l'élément conducteur d'un film de protection (14) en polyéthylènetéréphtalate (PET), ou en polychlorure de vinyle (PVC), ou en polypropylène, ou encore en polyéthylène haute densité, et d'épaisseur inférieure ou égale à 60 µm.

9. Structure selon l'une quelconque des revendications 1 à 4, **caractérisée en ce que** l'élément conducteur (11) est constitué d'une couche métallique, telle qu'à base d'argent, déposée sur une feuille de support qui est constituée par la feuille de recouvrement (12), ledit élément étant agencé entre la feuille de recouvrement et la première feuille en matière thermoplastique (10).

10. Structure selon la revendication 6 ou 9, **caractérisée en ce que** la feuille de support de l'élément conducteur est constituée d'une feuille complémentaire en matière plastique (13) qui est feuilletée entre la première feuille thermoplastique (10) et la feuille de recouvrement (12).

11. Structure selon l'une quelconque des revendications précédentes, **caractérisée en ce que** la première feuille en matière thermoplastique (10), et la feuille de recouvrement (12) lorsqu'elle ne constitue pas une feuille de support pour l'élément conducteur sont en polyvinylbutyral, ou en polyuréthanne, ou en ethylène-vinyl-acétate.

12. Structure selon l'une quelconque des revendications précédentes, **caractérisée en ce qu'**elle est assemblée à un unique substrat transparent (20), la première feuille en matière thermoplastique (10) étant assemblée au substrat.

13. Structure selon l'une quelconque des revendications 1 à 11, **caractérisée en ce qu'**elle est assemblée en feuilleté entre deux substrats transparents (20, 21), la feuille en matière thermoplastique (10) et la feuille de recouvrement (12) étant respectivement assemblées à chacun des substrats (20, 21).

14. Structure selon la revendication 12 ou 13 associée à au moins un substrat transparent (20), **caractérisée en ce que** le substrat transparent (20) comporte sur sa face en regard de la feuille en matière thermoplastique une couche métallique telle qu'à base d'argent pour constituer l'élément conducteur (11) lorsque celui-ci est associé à la structure.

15. Structure selon la revendication 12 ou 13, **caractérisée en ce qu'**elle assure pour l'ensemble structure et substrat(s), un filtre infrarouge avec une transmission lumineuse correspondante T_{IR} n'excédant pas 22 %, et un filtre pour la couleur orange avec une transmission lumineuse correspondante T_{NE} comprise entre 20 % et 40 %, l'ensemble structure et substrat(s) présentant un taux de transmission lumineuse dans le visible compris entre 40 % et 60 %, avec une pureté inférieure à 3 %.

16. Structure de blindage électromagnétique selon la revendication 15, **caractérisée en ce que** le filtre infrarouge assure une transmission à 815 nm d'au plus 22%, une transmission à 870 nm d'au plus 18% et une transmission entre 900 et 1250 nm d'au plus 12%.

17. Ecran de visualisation, notamment écran plasma, comportant en face avant (2) une structure (1) selon l'une quelconque des revendications 12 à 16.

18. Ecran selon la revendication 17, **caractérisé en ce qu'**au moins un substrat en verre (20, 21) est en verre trempé.

19. Ecran selon la revendication 17 ou 18, **caractérisé en ce qu'**au moins un des substrats en verre (20, 21) comporte une couche antireflets sur la face opposée à la structure.

20. Ecran selon l'une des revendications 17 à 19, **caractérisé en ce que** la feuille de recouvrement (12) comporte un traitement antireflets sur la face opposée à la première feuille en matière thermoplastique (10).

21. Ecran selon l'une des revendications 17 à 20, **caractérisé en ce que** la structure (1) est directement collée sur la face avant de l'écran.

## Patentansprüche

1. Aufbau (1) zum optischen Filtern und elektromagnetischen Abschirmen, der vorgesehen ist, mit mindestens einem transparenten Substrat (20), speziell aus Glas, verbunden zu werden, wenigstens zwei Kunststofffolien (10, 12) enthält und die Folien (10, 12) und ein elektromagnetisch abschirmendes leitfähiges Element (11) umfasst oder vorgesehen ist, damit verbunden zu werden, **dadurch gekennzeichnet, dass** mindestens eine Folie (10) aus einem Thermoplast und die andere Folie (12) aus einer das leitfähige Element (11) oder die Thermoplastfolie (10) bedeckenden Folie besteht, wobei in eine oder in die zwei Folien wenigstens ein anorganisches Pigment oder wenigstens ein organischer Farbstoff derart eingebaut ist, dass für den Aufbau (1) ein Filter in der Farbe Orange mit einer Mittenwellelänge von 590 nm erhalten wird.

2. Aufbau nach Anspruch 1, **dadurch gekennzeichnet, dass** in mindestens eine der Folien, die Thermoplastfolie (10) und/oder die Deckfolie (12), wenigstens ein anorganisches Pigment oder wenigstens ein organischer Farbstoff eingebaut ist, um einen Infrarotfilter in einem Wellenlängenbereich von 800 bis 1250 nm zu bilden.

3. Elektromagnetisch abschirmender Aufbau nach Anspruch 2, **dadurch gekennzeichnet, dass** eine der Folien (10, 12) neutral ist, während die andere mindestens zwei Pigmente oder Farbstoffe enthält, die durch den Aufbau hindurch den Filter für die orange Farbe bzw. den Infrarotfilter sicherstellen.

4. Elektromagnetisch abschirmender Aufbau nach Anspruch 2, **dadurch gekennzeichnet, dass** die Thermoplastfolie (10) ein Pigment oder einen Farbstoff enthält, das/der durch den Aufbau hindurch den Filter für die orange Farbe oder den Infrarotfilter sicherstellt, und die Deckfolie (12) ein Pigment oder einen Farbstoff enthält, das/der den Filter für die orange Farbe oder den Infrarotfilter sicherstellt, der von der anderen Thermoplastfolie (10) nicht sichergestellt wird.

5. Aufbau nach einem der vorhergehenden Ansprüche, **dadurch gekennzeichnet, dass** das leitfähige Element (11) aus einem Metalldrahtgewebe besteht, das zwischen den zwei Folien (10, 12) eingebaut ist.

6. Aufbau nach einem der Ansprüche 1 bis 4, **dadurch gekennzeichnet, dass** das leitfähige Element (11) aus einem Metalldrahtgitter besteht, das auf einer tragenden Folie aufgebracht ist, die auf der Basis eines der Stoffe Polycarbonat, Polymethyl(meth)acrylat, Polyethylenterephthalat, Polyethersulfon, Polyetherketon und Acrylnitril-Styrol-Copolymer zusammengesetzt ist.

7. Aufbau nach Anspruch 6, **dadurch gekennzeichnet, dass** die das leitfähige Element tragende Folie aus der Deckfolie (12) besteht, wobei das leitfähige Element (11) zwischen der thermoplastischen ersten Folie (10) und der Deckfolie (12) angeordnet ist.

8. Aufbau nach Anspruch 6 oder 7, **dadurch gekennzeichnet, dass** die Deckfolie (12), die das leitfähige Element (11) trägt, auf der dem leitfähigen Element abgewandten Seite mit einem Schutzfilm (14) aus Polyethylenterephthalat (PET), Polyvinylchlorid (PVC), Polypropylen oder Polyethylen mit hoher Dichte und mit einer Dicke von kleiner als oder gleich 60 µm beschichtet ist.

9. Aufbau nach einem der Ansprüche 1 bis 4, **dadurch gekennzeichnet, dass** das leitfähige Element (11) aus einer Metallschicht wie einer auf der Basis von Silber besteht, die auf einer tragenden Folie aufgebracht ist, die aus der Deckfolie (12) besteht, wobei dieses Element zwischen der Deckfolie und der thermoplastischen ersten Folie (10) angeordnet ist.

10. Aufbau nach Anspruch 6 oder 9, **dadurch gekennzeichnet, dass** die das leitfähige Element tragende Folie aus einer komplementären Kunststofffolie (13) besteht, die zwischen der ersten Thermoplastfolie (10) und der Deckfolie (12) angeordnet ist.

11. Aufbau nach einem der vorhergehenden Ansprüche, **dadurch gekennzeichnet, dass** die erste Thermoplastfolie (10) und die Deckfolie (12), wenn sie keine tragende Folie für das leitfähige Element bildet, aus Polyvinylbutyral, Polyurethan oder Ethylen-Vinylacetat bestehen.

12. Aufbau nach einem der vorhergehenden Ansprüche, **dadurch gekennzeichnet, dass** er mit einem einzigen transparenten Substrat (20) verbunden ist, wobei die erste Thermoplastfolie (10) mit dem Substrat verbunden ist.

13. Aufbau nach einem der Ansprüche 1 bis 11, **dadurch gekennzeichnet, dass** er als ein Verbundaufbau zwischen zwei transparenten Substraten (20, 21) eingebaut ist, wobei die Thermoplastfolie (10) und die Deckfolie (12) jeweils mit einem der Substrate (20, 21) verbunden sind.

14. Aufbau nach Anspruch 12 oder 13, der mit mindestens einem transparenten Substrat (20) verbunden ist, **dadurch gekennzeichnet, dass** das transparente Substrat (20) auf der zur Thermoplastfolie zeigenden Seite eine Metallschicht wie eine auf der Basis von Silber umfasst, um das leitfähige Element (11) zu bilden, wenn dieses mit dem Aufbau verbunden ist.

15. Aufbau nach Anspruch 12 oder 13, **dadurch gekennzeichnet, dass** er für die Einheit aus Aufbau und Substrat(en) einen Infrarotfilter mit einem entsprechenden Lichttransmissionsgrad T_{IR}, der 22 % nicht übersteigt, und einen Filter für die orange Farbe mit einem entsprechenden Lichttransmissionsgrad T_{NE} von 20 bis 40 % sicherstellt, wobei die Einheit aus Aufbau und Substrat(en) einen Lichttransmissionsgrad im sichtbaren Bereich von 40 bis 60 % mit einem spektralen Farbanteil von unter 3 % besitzt.

16. Elektromagnetisch abschirmender Aufbau nach Anspruch 15, **dadurch gekennzeichnet, dass** von dem Infrarotfilter eine Transmission bei 815 nm von höchstens 22 %, eine Transmission bei 870 nm von höchstens 18 % und eine Transmission zwischen 900 und 1 250 nm von höchstens 12 % sichergestellt wird.

17. Bildschirm, insbesondere Plasmabildschirm, der als Vorderseite (2) einen Aufbau (1) nach einem der Ansprüche 12 bis 16 umfasst.

18. Bildschirm nach Anspruch 17, **dadurch gekennzeichnet, dass** mindestens ein Glassubstrat (20, 21) vorgespannt worden ist.

19. Bildschirm nach Anspruch 17 oder 18, **dadurch gekennzeichnet, dass** mindestens eines der Glassubstrate (20, 21) auf der dem Aufbau abgewandten Seite eine Antireflexschicht umfasst.

20. Bildschirm nach einem der Ansprüche 17 bis 19, **dadurch gekennzeichnet, dass** die Deckfolie (12) eine Antireflexbehandlung auf der der ersten Thermoplastfolie (10) abgewandten Seite erfahren hat.

21. Bildschirm nach einem der Ansprüche 17 bis 20, **dadurch gekennzeichnet, dass** der Aufbau (1) direkt auf die Vorderseite des Bildschirms geklebt wird.

## Claims

1. Optical filtering/electromagnetic screening structure (1) for being joined to at least one transparent substrate (20), especially made of glass, the structure comprising at least two plastic sheets (10, 12) and including, or intended to be joined to the sheets (10, 12), a conducting electromagnetic screening element (11), **characterized in that** at least one sheet (10) is made of a thermoplastic, the other sheet (12) constitutes a sheet for covering the conducting element (11) or the thermoplastic sheet (10), and either one or both of the two sheets incorporate at least one mineral pigment or at least one organic dye so as to produce, in respect of the structure (1), an orange filter for light of wavelength centred on 590 nm.

2. Structure according to Claim 1, **characterized in that** at least one of the sheets, namely the thermoplastic sheet (10) and/or the covering sheet (12), incorporates at least one mineral pigment or at least one organic dye in order to form an infrared filter in the 800 to 1250 nm wavelength range.

3. Electromagnetic screening structure according to Claim 2, **characterized in that** one of the two sheets (10, 12) is neutral while the other sheet includes at least two pigments or dyes that provide, through the structure, the orange filter and the infrared filter, respectively.

4. Electromagnetic screening structure according to Claim 2, **characterized in that** the thermoplastic sheet (10) includes a pigment or a dye that provides, through the structure, the orange filter or the infrared filter and the covering sheet (12) includes a pigment or dye that provides the orange filter or the infrared filter that the other, thermoplastic, sheet (10) does not provide.

5. Structure according to any one of the preceding claims, **characterized in that** the conducting element (11) is formed from a metal wire gauze joined between the two sheets (10, 12).

6. Structure according to any one of Claims 1 to 4, **characterized in that** the conducting element (11) is formed from a metal wire mesh deposited on a support sheet whose composition is based on one of the following materials: polycarbonate, polymethyl (meth)acrylate, polyethylene terephthalate, polyethersulphone, polyetherketone and acrylonitrile-styrene copolymer.

7. Structure according to Claim 6, **characterized in that** the support sheet for the conducting element constitutes the covering sheet (12), the conducting element (11) being placed between the thermoplastic first sheet (10) and the covering sheet (12).

8. Structure according to Claim 6 or 7, **characterized in that** the covering sheet (12) bearing the conducting element (11) is coated on the opposite side from the conducting element with a protective film (14) made of polyethylene terephthalate (PET), or of polyvinyl chloride (PVC) or of polypropylene or of high-density polyethylene, with a thickness of less than or equal to 60 µm.

9. Structure according to any one of Claims 1 to 4, **characterized in that** the conducting element (11) is formed from a metal layer, such as one based on silver, deposited on a support sheet that is formed by the covering sheet (12), the said element being placed between the covering sheet and the thermoplastic first sheet (10).

10. Structure according to Claim 6 or 9, **characterized in that** the support sheet, for the conducting element is formed from a complementary plastic sheet (13) that is laminated between the thermoplastic first sheet (10) and the covering sheet (12).

11. Structure according to any one of the preceding claims, **characterized in that** the thermoplastic first sheet (10) and the covering sheet (12) when it does not constitute a support sheet for the conducting element are made of polyvinyl butyral, or of polyurethane, or of ethylene-vinyl acetate.

12. Structure according to any one of the preceding claims, **characterized in that** it is joined to a single transparent substrate (20), the thermoplastic first sheet (10) being joined to the substrate.

13. Structure according to any one of Claims 1 to 11, **characterized in that** it is laminated between two transparent substrates (20, 21), the thermoplastic sheet (10) and the covering sheet (12) being joined to each of the substrates (20, 21), respectively.

14. Structure according to Claim 12 or 13, joined to at least one transparent substrate (20), **characterized in that** the transparent substrate (20) has, on its face that faces the thermoplastic sheet, a metal layer such as one based on silver in order to form the conducting element (11) when the latter is joined to the structure.

15. Structure according to Claim 12 or 13, **characterized in that** it provides, in respect of the structure/substrate(s) assembly, an infrared filter with a corresponding light transmission T_{IR} not exceeding 22%, and an orange filter with a corresponding light transmission T_{NE} of between 20% and 40%, the structure/substrate(s) assembly having a light transmission coefficient in the visible of between 40% and 60%, with a less than 3% purity.

16. Electromagnetic screening structure according to Claim 15, **characterized in that** the infrared filter ensures transmission at 815 nm of at most 22%, transmission at 870 nm of at most 18% and transmission between 900 and 1250 nm of at most 12%.

17. Display screen, especially a plasma screen, having on the front face (2) a structure (1) according to any one of Claims 12 to 16.

18. Screen according to Claim 17, **characterized in that** at least one glass substrate (20, 21) is made of toughened glass.

19. Screen according to Claim 17 or 18, **characterized in that** at least one of the glass substrates (20, 21) has an antireflection coating on the opposite face from the structure.

20. Screen according to one of Claims 17 to 19, **characterized in that** the covering sheet (12) has an antireflection coating on the opposite face from the thermoplastic first sheet (10).

21. Screen according to one of Claims 17 to 20, **characterized in that** the structure (1) is adhesively bonded directly to the front face of the screen.
